# EUROPEAN PATENT APPLICATION

(11) **EP 1 061 677 A2**
(43) Date of publication of application: **20.12.2000**
(21) Application number: 00304107.6
(22) Date of filing: 16.05.2000
(51) Int. Cl.: H04H 1/00

(54) **Apparatus for mapping the geographic coverage of a broadcast signal**

(30) Priority: 21.05.1999 GB 9911758
(71) Applicant: Pace Micro Technology PLC, Shipley, West Yorkshire BD18 3LF (GB)
(72) Inventor: Coe, Peter, Skipton, North Yorkshire BD23 2TE (GB); Mountain, Dale, Sandy Lane, Bradford BD15 9LB (GB)
(74) Representative: Wood, Graham

(57) **Abstract**

Apparatus and a system is provided for a broadcast data receiver for transmitted data which allows, especially during the installation of the receiver at a specified location, a means to monitor the strength of the received signal at one or a series of frequencies. A reading indicative of the strength can be obtained, displayed or transmitted to a broadcaster for the generation of a database of a signal strengths at different locations.

## Description

The invention to which this application relates is apparatus and a method for improving the ability to provide a map or mapping of reception of broadcast data whether the data be for use in radio, television, satellite or any other broadcast data transmission system.

At the present time, it is necessary for broadcasters of data to be able to identify the strength of signal on which the data is carried at various locations of reception. In order to do this, at the present time, a graphical map of the received RF signal strength is created by using locally measured limited signal strengths and referring to topographical maps for that location. Thus, with the combination of the local signal strength measurement and the topographical maps, a graphical representation can be created in an effort to indicate to broadcasters areas where the signal strength is good, fair or poor. The broadcaster and/or the installers of apparatus can refer to the graphical representations and install receiving apparatus in an appropriate manner and in an appropriate configuration at the locations in accordance with the graphical representation.

The present method is inherently flawed in that it cannot take into account or identify differences in reception in relatively small areas as it is impractical for the method described above to be carried out and this means that for example, a village which has a poor reception but which lies in an area of generally good reception, will not be indicated on the graphical representation and, when apparatus is to be installed in that particular locality, the reception of the data may not meet the required standard.

The aim of the present invention is to provide apparatus and a method for creating a database, which may be graphically represented, and which may be referred to when installing data receiving apparatus at specific locations and to provide a database with more accurate and locally defined information.

In a first aspect of the invention there is provided apparatus for use in determining the strength of a broadcast signal received at the location of said apparatus, said apparatus comprising a receiver for receiving said broadcast data at a specified location and wherein said receiver, upon receiving said broadcast data signal at the location, is operable to store a value indicative of the strength of the received signal.

In one embodiment the receiver processes the received signal and generates a value indicative of the signal strength. In one embodiment, the receiver has the capability to record the signal strength value and/or any combination of transmitting the signal strength value to the broadcaster, typically via a modem link and/or may display the signal strength value at the receiver for the reference of an installer.

In one utilisation of the invention the measurement of the signal strength at the location can be repeated for signals at a number of different frequencies so enabling the signal strength at different receiver frequencies to be assessed at the location.

In a second aspect there is provided a system for the generation of a database of signal strength values at a series of known locations for subsequent reference upon the installation of receiving apparatus at said location, said data base generated by transmitting from broadcast data receiving apparatus at said location a signal strength value to a collater of the data, along with a signal indicating the location of the receiver at that instant, and from the signals received, the database is created.

It is preferred that, at least initially in the setting up of the database of signal strength values, the receivers transmit a signal strength value to the broadcaster upon each installation, typically, along with a signal indicating the location of the receiver at that instant. From the data received by the broadcaster, the database is created and as the locations of the values received are known, the same can be collated into regions, towns villages etc and even, if required, used to identify specific house locations or street locations and so on.

Thus, the ability for the receiver to be provided with apparatus or to be provided in conjunction with apparatus to receive a broadcast signal, identify the strength of the received signal, and then store, record, transmit and/or display the said value, allows an accurate database to be created which is location specific and therefore can be used as reference by broadcasters and installers of apparatus thereafter.

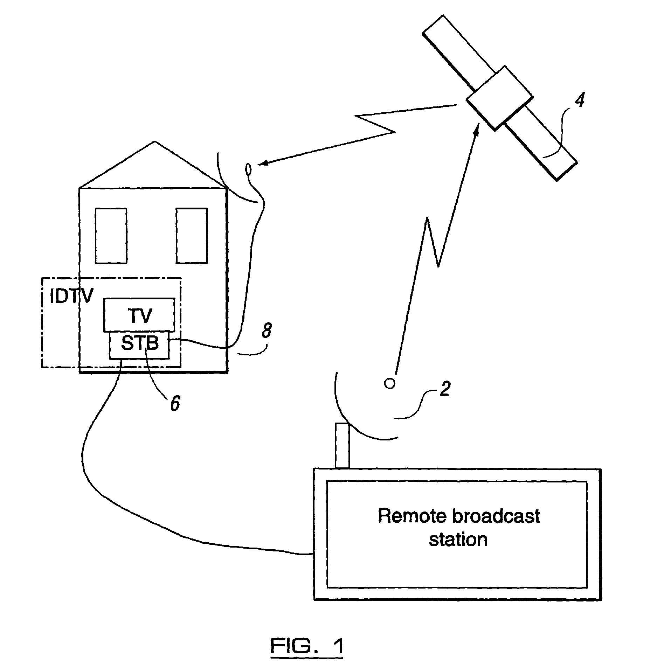

A specific embodiment of the invention will now be described with reference to the accompanying drawing, wherein the drawing illustrates in schematic fashion, apparatus and method for use in the current invention.

The apparatus in this example of the drawing illustrates a satellite broadcast system but it should be appreciated that the apparatus and system can equally be applied to terrestrial television broadcast systems, radio, mobile telephone and any other broadcast system.

The apparatus shown comprises a remote broadcast system 2 from which the broadcast signal is transmitted to a satellite 4 and from the satellite, is received by receiver 6 at a location 8. The receiver is typically connected to a television set or monitor for the display and/or generation of visual and/or audio display or may be provided as a radio or mobile telephone or so on. In any case, the receiver is provided with receiving means to allow the reception of the broadcast signal and processing means to allow the processing of the signal to provide the required audio and/or visual display. The receiver is also provided with a means for detecting the strength of the broadcast signal received and then generating a value to represent the strength of signal. The value can be displayed to allow the person installing the receiver to make adjustments to the same if required so as to allow the best signal reception to be obtained, the value may be stored to allow the same to be referred to at a later time and/or the value may be transmitted. If the signal strength value is transmitted it is envisaged that a modem connection 10 which is typically provided with the receiver 6, can be used and which allows the communication of the value via a telephone line to the broadcaster of the signal. It should be appreciated that although described in relation to a satellite broadcast system, the invention can be used with any broadcast signal system to measure the strength of the signal at specified locations.

Other potential uses are to be able to measure the effect on receiver signal strength at different frequencies due to modifications, improvements or maintenance on transmitters, aerial arrays or on other apparatus which may be believed to have an effect, remotely at the transmitter site by assessment of the signal values received and even as the modification work is taking place with communications being sent to the point of work as required. A further use is to allow an assessment of the effects of building work or structures such as pylons on the signal strength at various frequencies by comparing the signal strength values before, during and after the work.

The broadcaster of the signal, or governing body can receive a number of signal strength values from a number of different locations over a period of time and, by logging these signals, a database can be created which indicates the broadcast signal strength at locations throughout the country. These values can also be processed in groups into regions, counties, towns, villages, even houses and specific streets and/or a graphical representation generated which is based on accurate and true broadcast signal strength values rather than predicted signal strength values which is presently the case.

## Claims

1. Apparatus for use in determining the strength of a broadcast signal received at the location of said apparatus, said apparatus comprising a receiver for receiving said broadcast data at a specified location and wherein said receiver, upon receiving said broadcast data signal at the location, is operable to store a value indicative of the strength of the received signal.

2. Apparatus according to claim 1 wherein the receiver processes the received signal and generates a value indicative of the signal strength.

3. Apparatus according to claim 1 wherein the receiver has the capability to record the signal strength value and transmit the signal strength value to a remote location.

4. Apparatus according to claim 1, wherein the receiver displays the signal strength value for the reference of an installer.

5. Apparatus according to claim 1 wherein the measurement of the signal strength at the location is repeated for a series of signals at a number of different frequencies of signal so enabling the signal strength at different receiver frequencies to be assessed at the location.

6. A system for the generation of a database of signal strength values at a series of known locations for subsequent reference upon the installation of receiving apparatus at said location, said data base generated by transmitting from broadcast data receiving apparatus at said location a signal strength value to a collater of the data, along with a signal indicating the location of the receiver at that instant, and from the signals received , the database is created.

7. A system according to claim 6 wherein as the locations of the values received are known, the same are collated into specified areas and/or specific house locations or street locations.
